# EUROPÄISCHE PATENTANMELDUNG

(11) **EP 2 288 245 A2**
(43) Veröffentlichungstag der Anmeldung: **23.02.2011**
(21) Anmeldenummer: 10008214.8
(22) Anmeldetag: 06.08.2010
(51) Int. Cl.: H05K 5/06, H02B 1/28

(54) **Gehäuse für eine elektrische Einrichtung**

(30) Priorität: 18.08.2009 DE 102009037948
(71) Anmelder: Bartec GmbH, 97980 Bad Mergentheim (DE)
(72) Erfinder: Lux, Karl-Heinz, 97990 Weikersheim (DE)

(57) **Zusammenfassung**

Das Gehäuse ist für eine elektrische Einrichtung vorgesehen und hat Seitenwände und einen Deckel, die einen explosions-geschützten Innenraum für elektrische/elektronische Bauteile umgeben. In den Seitenwänden ist wenigstens eine Armierung untergebracht, die sich bis in den Deckel erstreckt. Dadurch ist das Gehäuse für hohe Explosionsdrücke geeignet. Die Armierung in den Seitenwänden und im Deckel sorgt dafür, dass sich die Seitenwände und der Deckel bei einem Explosionsdruck nicht ausdehnen oder verformen oder gar zerstört werden können. Das Gehäuse kann groß gebaut sein, da die Druckfestigkeit aufgrund der Armierung hoch ist.

## Beschreibung

### Beschreibung

Gehäuse für eine elektrische Einrichtung

Die Erfindung betrifft ein Gehäuse für eine elektrische Einrichtung nach dem Oberbegriff des Anspruches 1.

In derartigen Gehäusen sind elektromechanische, elektrische und elektronische Bauteile untergebracht. In die Seitenwände des Gehäuses können Verbindungsleiter eingebettet sein. Die Verbindungsleiter führen zu einer Festigkeitserhöhung des Gehäuses, das eine druckfeste Kapselung bildet. Allerdings ist ein derartiges Gehäuse nur für verhältnismäßig geringe Explosionsdrücke geeignet.

Der Erfindung liegt die Aufgabe zugrunde, das gattungsgemäße Gehäuse so auszubilden, dass es bei einfacher Herstellung und Gestaltung auch für höhere Explosionsdrücke geeignet ist.

Diese Aufgabe wird beim gattungsgemäßen Gehäuse erfindungsgemäß mit den kennzeichnenden Merkmalen des Anspruches 1 gelöst.

Das erfindungsgemäße Gehäuse ist für hohe Explosionsdrücke geeignet, da sich die Armierung von den Seitenwänden bis in den Deckel des Gehäuses erstreckt. Dadurch ist gewährleistet, dass sich die Wände und der Deckel des Gehäuses bei einem Explosionsdruck nicht ausdehnen oder verformen oder gar zerstört werden können. Aus diesem Grunde kann das erfindungsgemäße Gehäuse groß gebaut sein, da die Druckfestigkeit aufgrund der Armierung hoch ist.

Vorteilhaft erstreckt sich die Armierung über die ganze Fläche des Deckels. Dadurch ergibt sich eine optimal hohe Druckfestigkeit des erfindungsgemäßen Gehäuses.

Eine besonders einfache Ausbildung und Herstellung der Armierung ergibt sich, wenn sie durch ein Tiefziehteil gebildet wird. Die Armierung kann dann aus einem Blechteil durch einen Tiefziehvorgang einfach und kostengünstig hergestellt werden.

Die Armierung ist vorteilhaft napfförmig ausgebildet, so dass in den Seitenwänden und im Deckel jeweils eine vollflächige Armierung gewährleistet ist. Ein solches Gehäuse kann dementsprechend große Abmessungen aufweisen.

Das Tiefziehteil kann nach Art eines Lochbleches ausgebildet sein. Dadurch ist eine flächige und feste Verbindung zwischen der Armierung und dem Gehäuse möglich. Das Gehäuse besteht üblicherweise aus Kunststoff, der sich durch die Durchbrechungen des Lochbleches erstreckt und damit für eine formschlüssige Verbindung zwischen dem Gehäusematerial und der Armierung sorgt.

Es ist auch möglich, dass das Tiefziehteil geschlossene Wände aufweist. In diesem Falle gewährleistet die Armierung eine besonders hohe Druckfestigkeit des Gehäuses.

Wenn die Armierung zumindest teilweise als Stromführungsbauteil vorgesehen ist, kann die Armierung auch zur Stromzuleitung dienen.

In diesem Falle ist es vorteilhaft, wenn die Armierung aus einzelnen elektrisch leitenden Elementen gebildet ist, die durch wenigstens ein Halteelement zusammengehalten werden. Über die einzelnen elektrisch leitenden Elemente können gezielt bestimmte Bauteile innerhalb des Gehäuses mit Strom/Spannung versorgt werden. Das Halteelement sorgt dafür, dass diese Elemente zusammengehalten werden. Hierbei ist es vorteilhaft, dass die elektrisch leitenden Elemente mit dem Halteelement eine Baueinheit bilden. Sie kann dann in einfacher Weise in eine Spritzgussform eingelegt und mit dem die Gehäusewandung bildenden Kunststoff umspritzt werden.

Damit eine hohe Druckfestigkeit durch eine so ausgebildete Armierung gewährleistet ist, besteht das Halteelement vorteilhaft aus zugfestem Material, wie kohle- oder glasfaserverstärkter Kunststoff, mit entsprechender elektrischer Isoliereigenschaft.

Es ist von Vorteil, wenn an einige der elektrisch leitenden Elemente der Armierung elektrische Anschlüsse angeschlossen sind. Diese Anschlüsse können beispielsweise nach Art eines Zugbügelsystems oder einer Federklemme ausgebildet sein.

Vorteilhaft sind diese Anschlüsse an die freien Enden der elektrisch leitenden Elemente angeschlossen, die aus dem Deckel des Gehäuses ragen.

Damit diese elektrischen Anschlüsse einwandfrei isoliert sind, sind sie vorteilhaft in einem Isolierkörper untergebracht.

Er ist in vorteilhafter Weise auf dem Deckel angeordnet und kann dort aufgeschraubt, aufgerastet, aufgeklebt oder in anderer Weise befestigt sein.

Einige der elektrisch leitenden Elemente können über den Rand der Gehäuseseitenwände vorstehen, so dass an diese überstehenden Elemente Leitungen angeschlossen werden können.

Es ist möglich, den Deckel des Gehäuses mit wenigstens einer Gehäuseöffnung mit entsprechender Abdichtung zu versehen, über die eine Leitung oder dergleichen nach außen geführt werden kann.

Diese Gehäuseöffnung kann vorteilhaft von einem vom Deckel abstehenden Kragen begrenzt sein. Ebenso kann diese Gehäuseöffnung auch einen ex-begrenzenden Spalt haben für die Aufnahme von einem Stößel oder Betätigungsachse im Sinne des Explosionsschutzes.

Im Kragen kann auch ein Armierungsteil eingebettet sein, dadurch wird auch in diesem Bereich die mechanische Festigkeit deutlich erhöht.

Dieser Armierungsteil ist vorteilhaft einstückig mit der Armierung des Gehäuses ausgebildet, so dass nicht zwei unterschiedliche Armierungen vorgesehen werden müssen.

Das erfindungsgemäße Gehäuse kann durch einen Boden geschlossen sein. Es ist aber auch möglich, das Gehäuse aus einem Gehäuseteil und einem Halterahmen zu bilden, in den der Gehäuseteil eingreift.

Dieser Halterahmen hat vorteilhaft einen Boden und Seitenwände.

Zweckmäßig sind zumindest die Seitenwände des Halterahmens mit einer Armierung versehen, so dass auch der Halterahmen eine hohe Druckfestigkeit aufweist.

Vorteilhaft ist es, wenn auch zumindest ein Teil des Bodens des Halterahmens mit einer Armierung versehen ist.

Diese bodenseitige Armierung ist vorteilhaft Teil der Armierung in den Seitenwänden des Halterahmens. Dann ist auch für den Halterahmen nur eine einzige Armierung erforderlich, wodurch die Herstellung des Halterahmens vereinfacht wird.

Im montierten Zustand überlappt die Armierung des Halterahmens vorteilhaft die Armierung des Gehäuseteils. Dadurch wird erreicht, dass das komplette Gehäuse mit der Armierung versehen ist, wodurch sich eine besonders hohe Druckfestigkeit ergibt.

Der Gehäuseteil ist vorteilhaft mit der Außenseite seiner Seitenwände an der Innenseite der Seitenwände des Halterahmens anliegend befestigt, beispielsweise verklebt oder verschweißt. Dadurch ergibt sich eine dauerhafte, sichere und dichte Verbindung zwischen dem Gehäuseteil und dem Halterahmen.

Vorteilhaft ist der Gehäuseteil an seinem dem Halterahmen zugewandten Ende durch eine Vergussmasse geschlossen. Dadurch ist es möglich, in den Gehäuseteil sehr einfach die jeweiligen Bauteile einzusetzen. Anschließend wird der Gehäuseteil durch die Vergussmasse geschlossen, die beispielsweise aus Gießharz gebildet sein kann, wie Polyurethan- oder Epoxid-Harz.

Es ist aber auch möglich, dass die Vergussmasse in einem Aufnahmeraum vorgesehen ist, der zwischen den Seitenwänden des Gehäuseteiles und den Seitenwänden des Halterahmens gebildet ist. Dann muss der Gehäuseteil selbst keine Vergussmasse aufweisen. Dies hat den Vorteil, dass der Innenraum des Gehäuseteiles vergrößert ist, so dass bei gleicher Baugröße des Gehäuses mehr Einbauraum für die darin unterzubringenden Teile zur Verfügung steht.

Weitere Merkmale der Erfindung ergeben sich aus den weiteren Ansprüchen, der Beschreibung und den Zeichnungen.

Die Erfindung wird anhand einiger in den Zeichnungen dargestellter Ausführungsformen näher erläutert. Es zeigen
- Fig. 1: in perspektivischer Darstellung und in einem Teilschnitt eine erste Ausführungsform eines erfindungsgemäßen Gehäuses,
- Fig. 2: in einer Darstellung entsprechend Fig. 1 eine zweite Ausführungs- form eines erfindungsgemäßen Gehäuses, mit zum Teil stromfüh- renden Armierungen,
- Fig. 3: einen Teil des Gehäuses gemäß Fig. 2,
- Fig. 4: in vergrößerter Darstellung den Verbindungsbereich zwischen ei- nem Halterahmen und den Seitenwänden einer weiteren Ausfüh- rungsform eines erfindungsgemäßen Gehäuses,
- Fig. 5: in vergrößerter Darstellung einen Teil einer weiteren Ausführungs- form eines erfindungsgemäßen Gehäuses, das anstelle einer Lei- terplatte Anschlussklemmen aufweist,
- Fig. 6: im Schnitt einen Teil einer weiteren Ausführungsform eines erfin- dungsgemäßen Gehäuses, das mit Leitungen versehen ist,
- Fig. 7: in einer Darstellung entsprechend Fig. 1 eine weitere Ausführungs- form eines erfindungsgemäßen Gehäuses,
- Fig. 8: in einer Darstellung entsprechend Fig. 1 ein weiteres Ausfüh- rungsbeispiel eines erfindungsgemäßen Gehäuses,
- Fig. 9: im Schnitt eine ex"d"-Gehäuseöffnung des erfindungsgemäßen Gehäuses.

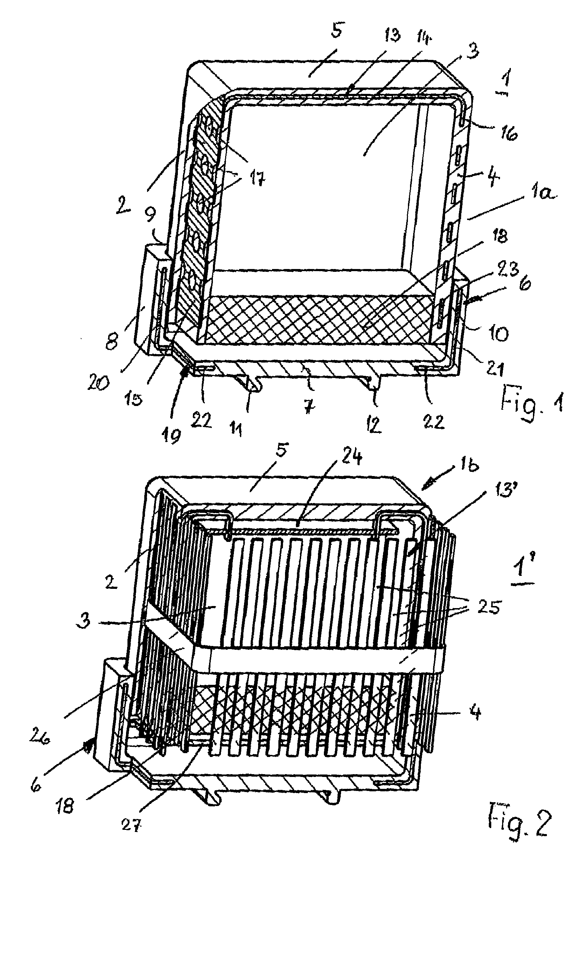

Das Gehäuse 1 gemäß Fig. 1 ist als ex-geschütztes Gehäuse einsetzbar, das trotz eines großen Innenvolumens eine hohe Druckfestigkeit aufweist. Das Gehäuse 1 gemäß Fig. 1 hat einen Gehäuseteil 1 a mit Seitenwänden 2 bis 4, die durch einen Deckel 5 miteinander verbunden sind. Die Seitenwände 2 bis 4 und der Deckel 5 sind einstückig miteinander aus Kunststoff hergestellt. Die eine Seitenwand des quaderförmigen Gehäuses 1 ist in Fig. 1 nicht erkennbar. Die Seitenwände 2 bis 4 sind gleich lang und greifen mit ihren freien Enden in einen napfartigen Halterahmen 6 ein. Die Seitenwände können auch unterschiedlich lang sein. Der Halterahmen 6 ist ebenfalls einstückig aus Kunststoff ausgebildet und hat einen Boden 7, von dem senkrecht gleich hohe Seitenwände 8 bis 10 abstehen. Die Seitenwände können aber auch unterschiedlich hoch sein. Die Seitenwände 2 bis 4 liegen mit ihren Außenseiten an den Innenseiten der Seitenwände 8 bis 10 an und sind druckdicht mit ihnen verbunden. Die freien Enden der Seitenwände 2 bis 4 können vom Boden 7 des Halterahmens 6 Abstand haben. Im Ausführungsbeispiel erstrecken sich die Seitenwände 8 bis 10 über weniger als die halbe Höhe der Seitenwände 2 bis 4. Je nach Einsatzfall des Gehäuses können die Seitenwände 8 bis 10 auch andere Höhen haben.

An der Unterseite des Bodens 7 befinden sich Haltestege 11, 12, die parallel zueinander liegen und sich vorteilhaft über die gesamte Breite des Bodens 7 erstrecken. Die Haltestege 11, 12 sind vorteilhaft einstückig mit dem Boden 7 ausgebildet. Mit ihnen wird das Gehäuse in bekannter Weise auf Tragschienen befestigt.

Der Gehäuseteil 1 a ist mit einer Armierung 13 versehen, durch welche das Gehäuse 1 die erforderliche Druckfestigkeit erhält. Die Armierung 13 wird durch einen Napf gebildet, dessen Boden 14 im Deckel 5 und dessen Seitenwände 15, 16 in den Seitenwänden 2 bis 4 des Gehäuses 1 liegen. Die Armierung 13 besteht aus metallischem Werkstoff und ist vollständig in das Gehäuse 1 eingebettet.

Im Ausführungsbeispiel sind die Seitenwände 15, 16 sowie der Boden 14 der napfförmigen Armierung 13 mit Durchbrechungen 17 versehen, die unterschiedliche Umrissformen haben können. Die Durchbrechungen 17 verringern das Gewicht der Armierung 13. Außerdem sorgen sie dafür, dass die Armierung 13 sicher im Gehäuseteil 1 a verankert ist, da der Kunststoff des Gehäuseteiles 1a die Durchbrechungen 17 durchdringt. Als Material für den Gehäuseteil 1 a kommt beispielsweise Polyamid oder Polycarbonat in Betracht.

Die Armierung 13 ist im dargestellten Ausführungsbeispiel aus einem Tiefziehblech napfförmig hergestellt. Als Armierung kann aber auch beispielhaft ein Drahtgitter verwendet werden, das ebenso wie das tiefgezogene Blech in den Kunststoff des Gehäuseteiles 1 a eingebettet ist.

Zur Herstellung des Gehäuseteiles 1a wird die Armierung 13 in eine Spritzgussform eingelegt und anschließend mit dem Kunststoff umspritzt. Nach der Fertigstellung ist der Gehäuseteil 1 a an der Unterseite offen, so dass die im Gehäuseteil 1 a unterzubringenden elektrischen/elektronischen Bauteile und Komponenten einfach montiert werden können. Nach der Montage dieser Teile wird der Boden des Gehäuseteiles 1a durch eine Vergussmasse 18 geschlossen. Sie kann aus Gießharz bestehen, zum Beispiel aus Polyurethan- oder aus Epoxid-Harz. Anstelle des Gießharzes kann auch jedes andere geeignete Material zum dichten Verschließen des Gehäuseteiles verwendet werden.

Auch der Halterahmen 6 ist mit einer Armierung 19 versehen, die in den Boden 7 und die Seitenwände 8 bis 10 eingebettet ist. Die Armierung 19 hat Seitenwände 20, 21, die in die Seitenwände 8 bis 10 des Halterahmens 6 eingebettet sind. Am unteren Ende sind die Seitenwände 20, 21 rechtwinklig zu einem umlaufenden Rahmenteil 22 abgebogen, der in den Boden 7 des Halterahmens 6 eingebettet ist.

Die Armierung 19 ist vorteilhaft ebenfalls aus einem Tiefziehblech hergestellt und kann ebenso wie die Armierung 13 mit Durchbrechungen versehen sein. Die Armierung 19 kann aber auch beispielhaft aus einem entsprechend gebogenen Drahtgitter bestehen.

Der Halterahmen 6 wird dann am Gehäuseteil 1 a vorgesehen, wenn dieser mit der Vergussmasse 18 geschlossen worden ist. Der Halterahmen 6 kann auf unterschiedliche Weise mit dem Gehäuseteil 1 a verbunden werden, beispielsweise durch Verkleben, Verschweißen, Verrasten, Verschrauben und dergleichen. Es ist auch eine Steckverbindung in dem Sinne möglich, dass der Gehäuseteil 1 und der Halterahmen 6 formschlüssig miteinander verbunden sind. Im dargestellten Ausführungsbeispiel ist zwischen den Seitenwänden 8 bis 10 des Halterahmens 6 und den Seitenwänden 2 bis 4 des Gehäuseteiles 1 eine Klebeschicht 23 vorgesehen, die die beiden Teile fest und dicht miteinander verbindet.

Der Gehäuseteil 1a ist im Ausführungsbeispiel etwa quaderförmig ausgebildet. Es kann selbstverständlich auch eine andere Form haben, beispielsweise zylindrisch ausgebildet sein.

Die Ausführungsform gemäß Fig. 2 unterscheidet sich von der vorigen Ausführungsform im Wesentlichen dadurch, dass die Armierung 13' gleichzeitig auch zur Stromführung dient. Im Gehäuseteil 1 b des Gehäuses 1' ist eine Leiterplatine 24 untergebracht, die beispielhaft mit geringem Abstand unterhalb des Deckels 5 des Gehäuseteiles 1 b angeordnet ist.

Die Armierung 13 weist einzelne, mit Abstand nebeneinander liegende Stromführungsteile 25 auf, die zum Beispiel durch Schienen gebildet sein können. Sie können beispielsweise aus Elektrolytkupfer, aus geeigneten Legierungen, wie Kupfer-Knetlegierungen oder Kupfer-Zink-Legierungen, und dergleichen bestehen. Vorteilhaft sind die Stromführungsteile 25 mit einem Oberflächenschutz versehen. Zu diesem Zweck können sie beispielsweise verzinnt oder vernickelt sein. Die Stromführungsteile 25 sind in den Seitenwänden 2 bis 4 des Gehäuseteiles 1 b eingebettet. Die Stromführungsteile 25 sind durch wenigstens ein Halteelement 26 miteinander verbunden, das vorteilhaft bandförmig ausgebildet und durch einen hochfesten Kunststoff gebildet ist. Das Halteelement 26 ist etwa in halber Länge der Stromführungsteile 25 angeordnet und umgibt sie. Das Halteelement 26 kann auf jede geeignete Weise fest mit den Stromführungsteilen 25 verbunden werden. Das Halteelement 26 kann beispielsweise aus kohlefaserverstärktem oder glasfaserverstärktem Kunststoff bestehen. Die Stromführungsteile 25 und das Halteelement 26 werden zu einer Einheit zusammengefügt, die anschließend in eine Spritzgussform eingelegt und mit dem Kunststoff zur Bildung des Gehäuseteiles 1 b umspritzt wird.

Wie bei der vorigen Ausführungsform wird nach der Montage der elektronischen/elektrischen Bauteile der Gehäuseteil 1 b mit der Vergussmasse 18 verschlossen.

Im Unterschied zur vorigen Ausführungsform steht die Armierung 13' nach unten über die Seitenwände 2 bis 4 des Gehäuseteiles 1 b vor. Die unteren Enden der Stromführungsteile 25 ragen in den Halterahmen 6, der gleich ausgebildet ist wie beim vorigen Ausführungsbeispiel. In den Halterahmen 6 ist eine Leiterplatine 27 eingesetzt, die mit einigen oder allen der Stromführungsteile 25, je nach Innenausbau des Gehäuses 1 b, verbunden werden kann.

Die Stromführungsteile 25 sind über das Halteelement 26, das aus elektrisch isolierendem Material besteht, elektrisch voneinander einwandfrei getrennt. An die Stromführungsteile 25 können die unterschiedlichsten Potentiale angelegt werden, die wiederum unterschiedlich kontaktiert werden können. Als Kontaktierung kann beispielsweise ein Klemmenanschluss, eine Leiterplattenkontaktierung, ein Lötanschluss mit Aderanschlüssen und dergleichen vorgesehen sein. Eine solche Gestaltung des Gehäuses 1 b erlaubt somit unterschiedlichste Gestaltungen, so dass das Gehäuse an den jeweiligen Einsatzfall optimal angepasst werden kann.

Wie Fig. 2 beispielhaft zeigt, sind zwei der Stromführungsteile 25 am oberen Ende etwa U-förmig abgewinkelt. Die abgewinkelten Enden sind in den Deckel 5 eingebettet und ragen nach unten aus ihm heraus. Das freie Ende ist mit der Leiterplatine 24 elektrisch leitend verbunden.

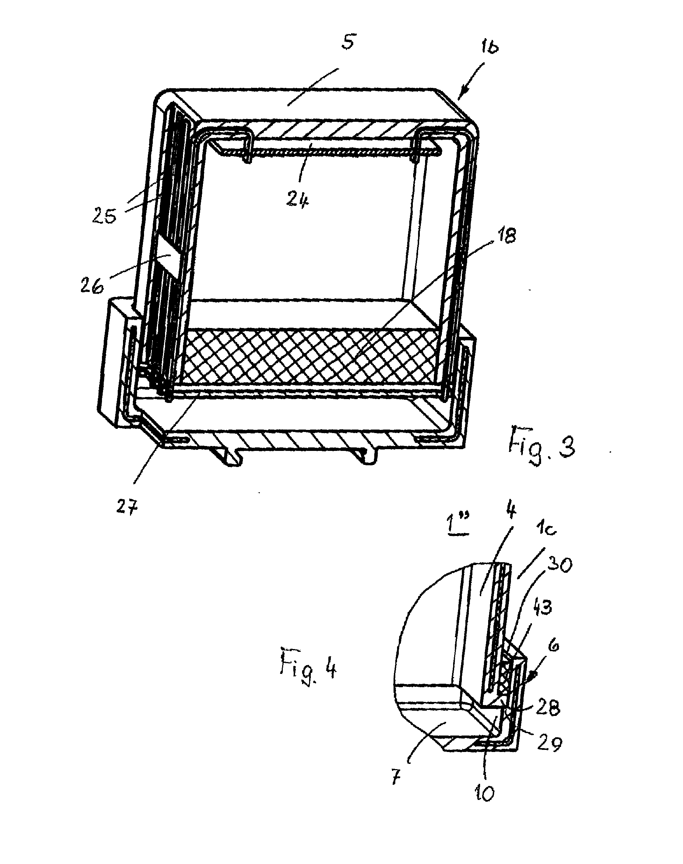

Fig. 4 zeigt die Möglichkeit, den Halterahmen 6 mittels einer Vergussmasse 43 am Gehäuseteil 1 c zu befestigen. Die Seitenwände 2 bis 4 des Gehäuseteiles sind hierfür am unteren Ende mit einem senkrecht nach außen abstehenden Rand 28 versehen, der bei montiertem Gehäuse 1" an der Innenseite der Seitenwände 8 bis 10 des Halterahmens 6 anliegt. Die Seitenwände 8 bis 10 des Halterahmens 6 sind an der Innenseite mit einem Absatz 29 versehen, auf dem der Rand 28 des Gehäuseteiles 1 c aufsitzt. Aufgrund des Absatzes 29 sind die Seitenwände 8 bis 10 an ihrem oberen Ende dünner als in ihrem an den Boden 7 anschließenden Bereich.

Aufgrund der beschriebenen Ausbildung wird zwischen dem unteren Ende der Seitenwände 2 bis 4 des Gehäuseteiles 1 c und dem oberen Bereich der Seitenwände 8 bis 10 des Halterahmens 6 ein umlaufender Aufnahmeraum 30 gebildet, in den die Vergussmasse 43 eingebracht wird, durch welche der Halterahmen 6 und der in ihn eingesetzte Gehäuseteil 1 c dicht und fest miteinander verbunden werden. Da die Vergussmasse 43 zwischen den Seitenwänden des Gehäuseteiles 1 c und dem Halterahmen 6 angeordnet ist, muss das untere Ende des Gehäuseteiles 1 c nicht durch eine Vergussmasse geschlossen werden. Dadurch steht auch der sonst für diese Vergussmasse benötigte Raum als Einbauraum zur Verfügung.

Im Übrigen kann das Gehäuse 1" entsprechend der Ausführungsform gemäß Fig. 1 oder den Fig. 2, 3 oder auch entsprechend den weiter noch zu beschreibenden Ausführungsformen ausgebildet sein.

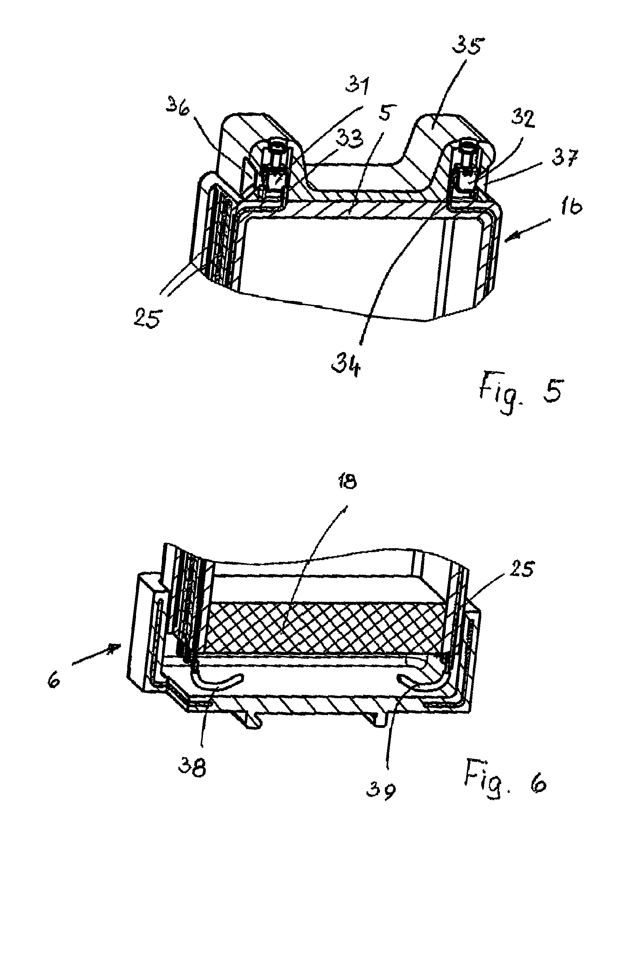

Fig. 5 zeigt die Möglichkeit, bei dem Gehäuse gemäß den Fig. 2 und 3 an die entsprechenden Stromführungsteile 25 Klemmenanschlüsse 31, 32 anzubringen. In diesem Falle sind die oberen Enden der entsprechenden Stromführungsteile 25 etwa Z-förmig gestaltet, wobei der Mittelteil in den Deckel 5 des Gehäuseteiles 1 b eingebettet ist und das freie Ende nach oben über den Deckel 5 vorsteht. An diesem vorstehenden Ende 33, 34 der Stromführungsteile 25 sind die Klemmenanschlüsse 31, 32 befestigt. Sie können beispielsweise in Form eines Zugbügelsystems oder einer Federklemme ausgebildet sein. Die Klemmenanschlüsse 31, 32 sind in einem Isolierkörper 35 untergebracht, der auf dem Deckel 5 befestigt wird, beispielsweise angeschraubt, aufgerastet oder angeklebt wird. Im Bereich der Klemmenanschlüsse 31, 32 ist der Isolierkörper 35 erhöht ausgebildet. Damit von außen die entsprechenden Leitungen an die Klemmenanschlüsse 31, 32 angebracht werden können, ist der Isolierkörper 35 mit Zugangsöffnungen 36, 37 versehen, über welche von außen die Leitungen an die Klemmenanschlüsse herangeführt und mit ihnen verbunden werden können. Der Isolierkörper 35 ist vorteilhaft mit hoher Kriechfestigkeit ausgeführt.

Fig. 6 zeigt die schon angesprochene Möglichkeit, an dem unteren, nach unten über die Vergussmasse 18 in den Halterahmen 6 ragenden Ende der entsprechenden Stromführungsteile 25 Leitungen 38, 39 anzubringen, die im Sinne der Explosionsschutzrichtlinien ausgeführt sind.

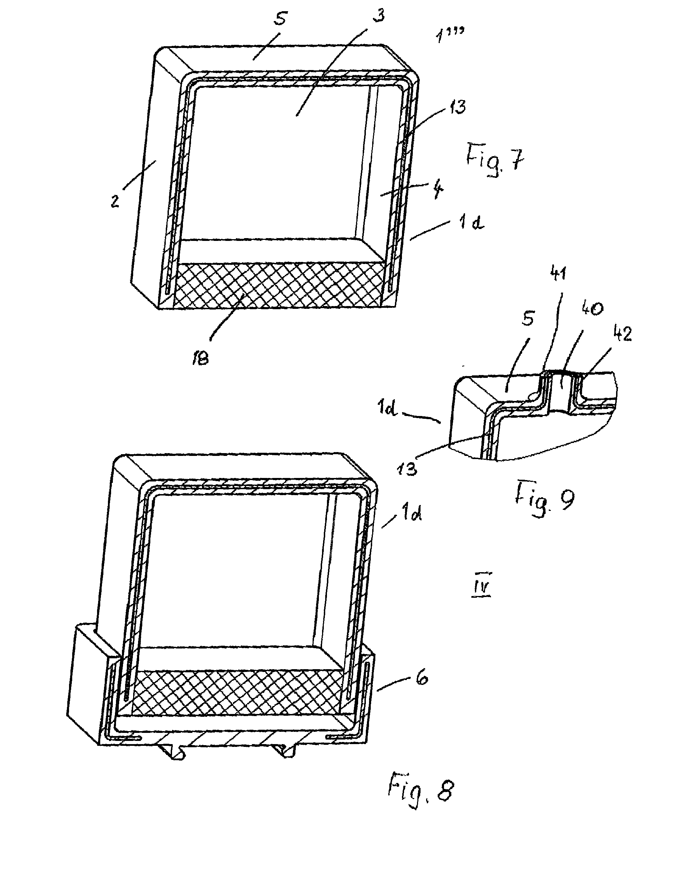

Die Fig. 7 zeigt ein Gehäuse 1 "', bei dem die Armierung 13 ähnlich wie bei der Ausführungsform nach Fig. 1 napfförmig durch Tiefziehen eines entsprechenden Bleches hergestellt ist. Im Unterschied zum Ausführungsbeispiel nach Fig. 1 sind im Tiefziehblech keine Durchbrechungen vorgesehen. Die Armierung 13 ist vollständig in den Gehäuseteil 1 d eingebettet und in dessen Seitenwänden 2 bis 4 und in dessen Deckel 5 vorgesehen. Im Übrigen ist der Gehäuseteil 1 d gleich ausgebildet wie der Gehäuseteil 1 a gemäß Fig. 1. Im Unterschied zu den vorigen Ausführungsbeispielen hat das Gehäuse 1"' keinen Halterahmen, sondern wird durch den Gehäuseteil 1d und die ihn verschließende Vergussmasse 18 gebildet.

Fig. 8 zeigt die Möglichkeit, den Gehäuseteil 1d in der beschriebenen Weise in den Halterahmen 6 einzusetzen, der gleich ausgebildet ist wie beim Ausführungsbeispiel nach Fig. 1. Der Halterahmen 6 und der Gehäuseteil 1d können auch eine Ausbildung entsprechend Fig. 4 haben.

Fig. 9 zeigt die Möglichkeit, im Deckel 5 des Gehäuseteils 1d wenigstens eine ex-d-Gehäuseöffnung 40 vorzusehen. Sie wird durch einen hochgestellten Rand 41 begrenzt, der einstückig mit dem Deckel 5 ausgebildet ist. Der Rand 41 ist ebenfalls mit einem Teil 42 der Armierung 13 versehen. Dieser Armierungsteil 42 ist vollständig in den Rand 41 eingebettet und kann sich bis zu dessen Stirnseite erstrecken. Der Armierungsteil 42 kann durch einen Aushalsvorgang an der Armierung 13 angebracht werden. Ebenso kann diese Gehäuseöffnung auch einen ex-begrenzenden Spalt haben für die Aufnahme von einem Stößel oder Betätigungsachse im Sinne des Explosionsschutzes.

Bei den beschriebenen Ausführungsbeispielen werden die Gehäuse 1, 1', 1", 1"' jeweils durch den Gehäuseteil 1a bis 1d und den Halterahmen 6 gebildet. Diese zweiteilige Ausbildung hat den Vorteil, dass beide Teile jeweils mit der Armierung 13, 19 versehen sein können. In montierter Lage überlappen die Armierungen 13, 19 einander über eine ausreichende Länge, so dass eine hohe Druckfestigkeit des Gehäuses erreicht wird. Die Überlappung der Seitenwände 2 bis 4 des Gehäuseteiles und der Seitenwände 8 bis 10 des Halterahmens 6 ist so groß, dass eine ausreichend feste Verbindung zwischen beiden Teilen gewährleistet ist. Bei der zweiteiligen Ausbildung aufgrund der allseitigen metallischen Armierung ist das Gehäuse für einen höheren Innendruck bei einer Explosion geeignet, ohne dass die Gefahr besteht, dass beim Explosionsvorgang das Gehäuse sich ausdehnt bzw. verformt oder gar bricht.

## Patentansprüche

1. Gehäuse für eine elektrische Einrichtung, mit Seitenwänden und einem Deckel, die einen explosionsgeschützten Innenraum umgeben, in dem elektrische/elektronische Bauteile untergebracht sind, und mit wenigstens einer Armierung, die in den Seitenwänden untergebracht ist, **dadurch gekennzeichnet, dass** sich die Armierung (13, 13') bis in den Deckel (5) erstreckt.

2. Gehäuse nach Anspruch 1,
**dadurch gekennzeichnet, dass** die Armierung (13) sich über die ganze Fläche des Deckels (5) erstreckt.

3. Gehäuse nach Anspruch 1 oder 2,
**dadurch gekennzeichnet, dass** die Armierung (13) durch ein vorzugsweise napfförmiges Tiefziehteil gebildet ist.

4. Gehäuse nach Anspruch 3,
**dadurch gekennzeichnet, dass** das Tiefziehteil nach Art eines Lochbleches ausgebildet ist.

5. Gehäuse nach Anspruch 3,
**dadurch gekennzeichnet, dass** das Tiefziehteil geschlossene Wände hat.

6. Gehäuse nach Anspruch 1,
**dadurch gekennzeichnet, dass** die Armierung (13') zumindest teilweise als Stromführungsbauteil vorgesehen und vorteilhaft aus einzelnen elektrisch leitenden Elementen (25) gebildet ist, die durch wenigstens ein Halteelement (26) zusammengehalten sind, das vorzugsweise aus zugfestem Material besteht, wie kohle- oder glasfaserverstärkter Kunststoff.

7. Gehäuse nach Anspruch 6,
**dadurch gekennzeichnet, dass** an einige der elektrisch leitenden Elemente elektrische Anschlüsse (31, 32) angeschlossen sind.

8. Gehäuse nach Anspruch 7,
**dadurch gekennzeichnet, dass** die elektrisch leitenden Elemente (25) mit ihren freien Enden (33, 34) aus dem Deckel (5) ragen, und dass die vorteilhaft in einem vorzugsweise auf dem Deckel (5) angeordneten Isolierkörper (35) untergebrachten elektrischen Anschlüsse (31, 32) an die freien Enden (33, 34) angeschlossen sind.

9. Gehäuse nach Anspruch 7 oder 8,
**dadurch gekennzeichnet, dass** einige der elektrisch leitenden Elemente (25) über den Rand der Seitenwände (2 bis 4) des Gehäuses (1') zum Anschluss von Leitungen (38, 39) vorstehen.

10. Gehäuse nach einem der Ansprüche 1 bis 9,
**dadurch gekennzeichnet, dass** der Deckel (5) des Gehäuses (1, 1', 1 ") mit wenigstens einer Gehäuseöffnung (40) versehen ist, die vorteilhaft von einem vom Deckel (5) abstehenden Kragen (41) begrenzt ist, in dem vorzugsweise ein einstückig mit der Armierung (13) ausgebildeter Armierungsteil (42) vorgesehen ist.

11. Gehäuse nach einem der Ansprüche 1 bis 10,
**dadurch gekennzeichnet, dass** das Gehäuse (1, 1', 1") aus einem Gehäuseteil (1a bis 1d) und einem Halterahmen (6) besteht, in den der Gehäuseteil (1 a bis 1 d) eingreift.

12. Gehäuse nach Anspruch 11,
**dadurch gekennzeichnet, dass** der Halterahmen (6) einen Boden (7) und vorzugsweise mit einer Armierung (19) versehene Seitenwände (8 bis 10) aufweist.

13. Gehäuse nach Anspruch 12,
**dadurch gekennzeichnet, dass** zumindest ein Teil des Bodens (7) des Halterahmens (6) mit einer Armierung (22) versehen ist, die vorteilhaft im Boden (7) Teil der Armierung (19) in den Seitenwänden (8 bis 10) des Halterahmens (6) ist.

14. Gehäuse nach einem der Ansprüche 11 bis 13,
**dadurch gekennzeichnet, dass** die Armierung (19) des Halterahmens (6) die Armierung (13) des Gehäuseteiles (1a bis 1d) überlappt, der vorteilhaft mit der Außenseite seiner Seitenwände (2 bis 4) an der Innenseite der Seitenwände (8 bis 10) des Halterahmens (6) anliegend befestigt und an seinem dem Halterahmen (6) zugewandten Ende durch eine Vergussmasse (18) geschlossen ist.

15. Gehäuse nach einem der Ansprüche 11 bis 14,
**dadurch gekennzeichnet, dass** zwischen den Seitenwänden (2 bis 4) des Gehäuseteiles (1 a bis 1 d) und den Seitenwänden (8 bis 10) des Halterahmens (6) ein Aufnahmeraum (30) für eine Vergussmasse (43) vorgesehen ist.
